# EUROPÄISCHE PATENTANMELDUNG

(11) **EP 1 589 562 A2**
(43) Veröffentlichungstag der Anmeldung: **26.10.2005**
(21) Anmeldenummer: 05008432.6
(22) Anmeldetag: 19.04.2005
(51) Int. Cl.: H01J 37/32

(54) **Plasmareaktor zu Oberflächenmodifikation von Gegenständen**

(30) Priorität: 20.04.2004 DE 102004019741
(71) Anmelder: centrotherm Photovoltaics GmbH + Co. KG, 89143 Blaubeuren (DE)
(72) Erfinder: Wanka, Harald Dr., 89143 Blaustein (DE); Heintze, Moritz Dr., 89073 Ulm (DE); Reichert, Johann Georg, 89143 Blaubeuren (DE); Völk, Hans-Peter, 89608 Griesingen (DE)
(74) Vertreter: Hudler, Frank

(57) **Zusammenfassung**

Die Erfindung betrifft einen Plasmareaktor zur Oberflächenbeschichtung oder -modifikation von Gegenständen bzw. Substraten mit Plasmaverfahren in einer Prozesskammer, vorzugsweise bei reduziertem Druck als Vakuumprozess, mit einer Eingangsschleuse zur Prozesskammer, sowie einer Ausgangsschleuse. Mit der Erfindung soll eine Plasmareaktor geschaffen werden, der bei gleichbleibend hoher Produktivität eine schnelle, einfache und selektive Reinigung der Plasmaquellen sowie angrenzender Bereiche der Prozesskammer ermöglicht wird. Erreicht wird das dadurch, dass in der Prozesskammer (1) mehrere, mindestens jedoch zwei Plasmazonen mit jeweils zugehörigen Plasmaquellen (2, 3; 15, 16) bzw. Remote- oder Downstream-Plasmaquellen (14) vorgesehen sind, wobei die Substrate (4) an den Plasmaquellen (2, 3;14; 15, 16) vorbei führbar sind und dabei den durch das Plasma mindestens einer der Plasmaquellen (2, 3;14; 15, 16) chemisch aktivierten Prozessgasen ausgesetzt sind und dass mindestens eine der Plasmaquellen (2, 3;14; 15, 16) selektiv von den zu bearbeitenden Substraten (4) und der Prozesskammer (1) isolierbar sind und dass der oder den isolierten Plasmaquellen (2, 3;14; 15, 16) und dem sie umgebenden Bereich der Prozesskammer (1) ein Ätzgas zuführbar ist.

## Beschreibung

Die Erfindung betrifft einen Plasmareaktor zur Oberflächenbeschichtung oder - modifikation von Gegenständen bzw. Substraten mit Plasmaverfahren in einer Prozesskammer, vorzugsweise bei reduziertem Druck als Vakuumprozess, mit einer Eingangsschleuse zur Prozesskammer, sowie einer Ausgangsschleuse.

Üblicher Weise kommen Plasmareaktoren in Prozesskammern, beispielsweise in der Halbleitertechnik zur Beschichtung von Wafern oder anderen Halbleiterstrukturen und sonstigen Substraten zum Einsatz, indem die Substrate, z.B. Wafer, über eine Eingangsschleuse in die Prozesskammer eingebracht werden, wobei nach dem Einbringen in die Prozesskammer ein für das nachfolgende Beschichtungs- oder Bearbeitungsverfahren geeigneter Druck durch eine Vakuumpumpe erzeugt wird. Sobald der erforderliche Druck, der beispielsweise bei 0,1 - 0,2 mbar liegen kann, erreicht wird, wird der Plasmareaktor, beispielsweise eine kapazitive Elektrode, mit einer Hochfrequenzquelle aktiviert, indem durch diese eine entsprechende Hochfrequenzenergie in die Elektrode eingeleitet wird. Gleichzeitig wird ein geeignetes Gas in die Prozesskammer eingeleitet.

Durch das Anlegen der Hochfrequenzenergie an die Elektrode wird das Prozessgas in der Prozesskammer ionisiert und das in der Prozesskammer (auch als Rezipient bezeichnet) befindliche Prozessgut dem Plasma ausgesetzt. Während des Behandlungsvorganges wird kontinuierlich frisches Prozessgas zugeführt und gleichzeitig verunreinigtes oder verbrauchtes Gas abgesaugt.

Nach der Bearbeitung des Substrates in der Prozesskammer wird dieses über eine Ausgangsschleuse, in der zunächst der normale Umgebungsdruck eingestellt wird, nach außen übergeben. Mit der Ausgangsschleuse wird zugleich sicher gestellt, dass keine Prozessgase in die Umwelt gelangen können.

Es ist allgemein bekannt, dass bei Beschichtungsprozessen in einer Bearbeitungskammer, z.B. einer Vakuumkammer, immer auch die Innenwandungen der Kammer sowie auch die Plasmaquelle selbst mit beschichtet werden. Diese Beschichtungen lassen sich nach dem bisher bekannt gewordenen Stand der Technik nicht verhindern. Das Ergebnis ist, dass die Produktivität solch einer Anlage durch die parasitären (unerwünschten) Beschichtungen an der Plasmaquelle oder den anderen Komponenten der Prozesskammer eingeschränkt wird. Bei Erreichen einer vorgegebenen Grenzschichtdicke müssen diese Ablagerungen entfernt werden.

Nach dem bisherigen Stand der Technik wird zum Beispiel, wie in der Mikroelektronik üblich, die Prozesskammer nach Erreichen der Grenzschichtdicke an der Plasmaquelle und den anderen Komponenten in-situ durch Ätzen, z.B. Plasmaätzen, gereinigt. Alternativ dazu kann die Prozesskammer natürlich auch belüftet, geöffnet und dann mechanisch gereinigt werden.

Nachteilig bei beiden Verfahren ist allerdings, dass die Produktivität der Anlage nicht unerheblich eingeschränkt wird, da während der Reinigung keine Beschichtungen durchgeführt werden können.

Der Erfindung liegt daher die Aufgabe zugrunde, einen Plasmareaktor zu schaffen, der bei gleichbleibend hoher Produktivität eine schnelle, einfache und selektive Reinigung der Plasmaquellen sowie angrenzender Bereiche der Prozesskammer ermöglicht wird.

Die der Erfindung zugrunde liegende Aufgabe wird bei einem Plasmareaktor der eingangs genannten Art dadurch gelöst, dass in der Prozesskammer mehrere, mindestens jedoch zwei Plasmazonen mit jeweils zugehörigen Plasmaquellen vorgesehen sind, wobei die Substrate an den Plasmaquellen vorbei führbar sind und dabei den durch das Plasma mindestens einer der Plasmaquellen chemisch aktivierten Prozessgasen ausgesetzt sind und dass mindestens eine der Plasmaquellen selektiv von den zu bearbeitenden Substraten und der Prozesskammer isolierbar sind und dass der oder den isolierten Plasmaquellen und dem sie umgebenden Bereich der Prozesskammer ein Ätzgas zuführbar ist.

Damit kann die Prozesskammer sowie der Plasmareaktor von parasitären Verunreinigungen befreit werden, ohne die Prozesskammer für eine externe Reinigung öffnen zu müssen, oder für die Dauer eines in-situ-Ätzens die Produktion (Beschichtung bzw. Oberflächenmodifikation) unterbrechen zu müssen.

In einer ersten Ausgestaltung der Erfindung sind für die Isolation einzelner Plasmaquellen Abdichtungen vorgesehen, die beispielsweise als linear verschiebbare Schieber, oder im Falle von linearen Plasmaquellen vor die Plasmaquelle schwenkbare Abschirmungen ausgebildet sein können.

Werden vor die Plasmaquelle schwenkbare Abschirmungen vorgesehen, ist es von Vorteil, wenn die Abschirmung bei Nichtgebrauch hinter die lineare Plasmaquelle schwenkbar ist.

Bei längs erstreckten Plasmaquellen besteht die Abschirmung jeder Plasmaquelle bevorzugt aus Zylindersegmenten.

Alternativ oder zusätzlich kann vorgesehen sein, dass die Isolation einzelner Plasmaquellen durch eine geeignete Gasführung in der Prozesskammer erfolgt, indem beispielsweise zwischen der isolierten Plasmaquelle und den übrigen Plasmaquellen ein Druckunterschied erzeugt wird.

Mit der erfindungsgemäßen Lösung ist es möglich, ein in-situ-Ätzen einzelner Plasmaquellen zum Beseitigen von parasitären Beschichtungen zu ermöglichen und dabei gleichzeitig die Behandlung der Substrate mit anderen Plasmaquellen fort zu setzen. Eine Unterbrechung des Behandlungsprozesses der Substrate zum Reinigungsätzen ist nicht mehr erforderlich. Das bedeutet einen erheblichen Produktivitätsgewinn.

Die Substrate durchlaufen in der Prozesskammer mehrere, mindestens aber zwei Plasmazonen, in denen sie dem durch das Plasma chemisch aktivierten Prozessgas ausgesetzt werden. In jeder Zone kann die Plasmaquelle durch eine geeignete Vorrichtung von den Substraten isoliert werden.

Anschließend werden der isolierten Plasmaquelle anstelle der Prozessgase Ätzgase zugeführt, so dass dann durch Plasmaätzen mit Hilfe der Ätzgase eine Reinigung der Plasmaquelle und der sie umgebenden Bereiche in der Prozesskammer von den parasitären Beschichtungen erfolgen kann.

Während dieses Vorganges können die Substrate an dieser Plasmaquelle vorbei geführt werden, ohne dass die Ätzgase auf deren Oberfläche einwirken können. Die Beschichtung oder Behandlung der Substrate erfolgt dann durch die andere(n) Plasmaquelle(n).

Werden zum Erreichen der geforderten Schichtwachstumsraten auf den Substrate mehrere Plasmaquellen hintereinander geschaltet, so können, falls erforderlich, zu jeder Zeit eine oder mehrere Plasmaquellen freigeätzt werden, ohne den Durchsatz der Substrate zu beeinträchtigen.

Die prozessmäßige Aufteilung einer Prozesskammer (Vakuumkammer) in unterschiedliche Zonen ist an sich bekannt. So werden in einer als Plasmabox bezeichneten Anordnung in einer Vakuumkammer gleichzeitig Schichten unterschiedlicher Zusammensetzung hergestellt.

Erfindungswesentlich ist hier jedoch, dass jede Plasmaquelle ohne nennenswerte Unterbrechung des Durchsatzes an Substraten zwischen den beiden Betriebszuständen - Abscheiden oder Ätzen - umgeschaltet werden kann. Dabei erfolgt die Isolation der Substrate und das Freiätzen (Reinigen) ohne Änderung der Lage von Substrat zu Elektrode, wobei eine gewisse Verschiebung z.B. der Elektrode innerhalb der Prozesskammer möglich ist.

Die Erfindung soll nachfolgend an einem Ausführungsbeispiel näher erläutert werden. In den zugehörigen Zeichnungsfiguren zeigen:
- Fig. 1:: eine schematische Darstellung von zwei nebeneinander in einer Prozesskammer angeordneten Plasmaquellen sowie darunter vorbei geführten Substraten, sowie einem Schieber, links in geöffneter und rechts in geschlossener Position;
- Fig. 2:: eine Variante der Erfindung, bei der die Reinigung mit beliebigen Remote- oder Downstream-Plasmaquellen erfolgt, wie z.B. induktiv gekoppelte oder auch Arcjet-Quellen; und
- Fig. 3: eine schematische Darstellung von zwei nebeneinander in einer Prozesskammer angeordneten Plasmaquellen mit darunter vorbei geführten Substraten, sowie einer schwenkbaren Abschirmung, links in geschlossener und rechts in geöffneter, also hinter die Plasmaquelle geschwenkter Position.

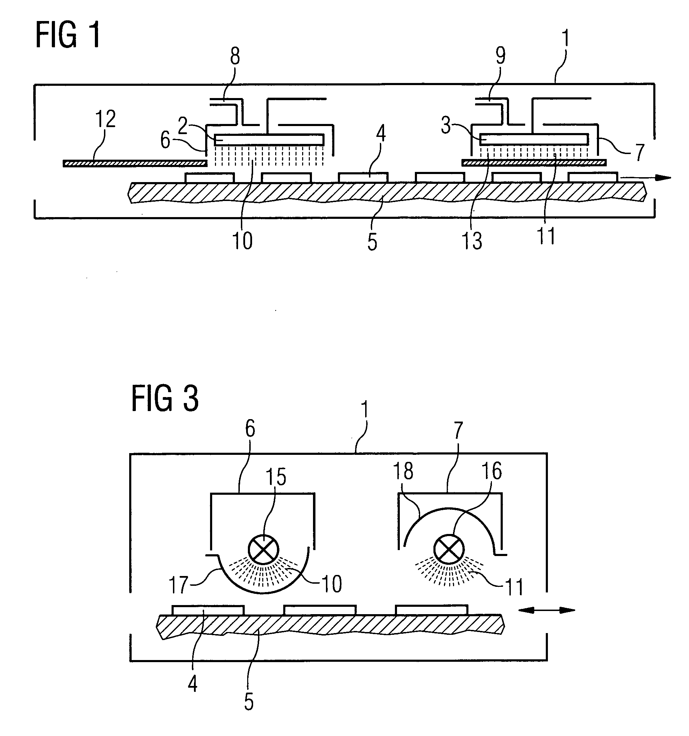

Aus Fig. 1 ist eine schematische Darstellung von zwei nebeneinander in einer Prozesskammer 1 angeordneten Plasmaquellen 2, 3 sowie mit darunter vorbei geführten Substraten 4 ersichtlich. Die Substrate 4 befinden sich dabei abstandsweise nebeneinander auf einem Substratträger 5, der unter den Plasmaquellen 2, 3 vorbei geführt wird. Die Plasmaquellen 2, 3 befinden sich jeweils innerhalb von Gehäusen 6, 7, die aus Quarzglas oder auch Metall bestehen können. Diese Abschirmungen 6, 7 sind mit Zuführeinrichtungen 8, 9 für Prozessgase und für Ätzgase versehen, mit denen jeweils nach dem jeweiligen Betriebszustand Prozessgase oder Ätzgase zuführbar sind. Die Plasmaquellen 2, 3 sind jeweils mit nicht dargestellten Hochfrequenzquellen verbunden, um das jeweils erforderliche Plasma 10, 11 erzeugen zu können. Weiterhin ist die Prozesskammer 1 mit einer nicht dargestellten Vakuumpumpe zum Erzeugen des notwendigen Vakuums verbunden.

Weiterhin sind unter jedem Gehäuse 6, 7 zwischen die Plasmaquelle 2; 3 und die Substrate 4 führbare Schieber 12, 13 vorgesehen, mit denen der jeweilige Plasmaraum weitgehend von den übrigen Bereichen der Prozesskammer abtrennbar ist, so dass das Plasma 11 die Substrate 4 nicht erreichen kann.

Fig. 1 links zeigt die Plasmaquelle 2 mit zugehörigem Plasma 10 im Beschichtungszustand und rechts die Plasmaquelle 3 im geschlossenen Zustand während des Reinigungsätzens.

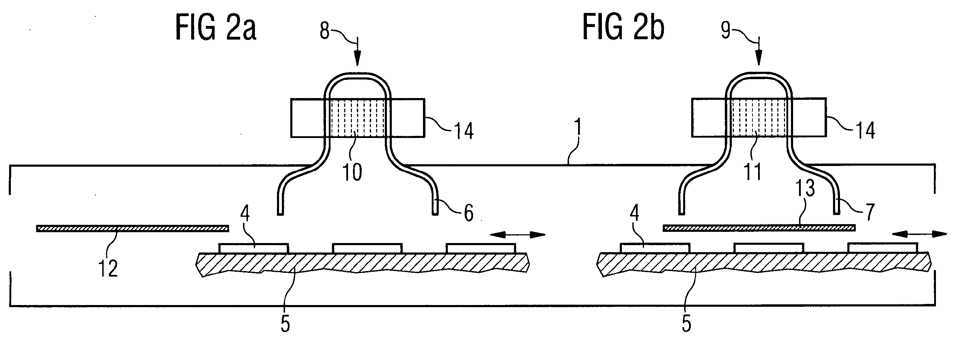

Fig. 2 zeigt eine schematische Darstellung des erfindungsgemäß ausgestalteten Prozesskammer 1 unter Verwendung von beliebigen Remote- oder Downstream- Plasmaquellen 14 mit Zuführeinrichtungen 8, 9 für Prozess- oder Ätzgase. Der zeichnungsgemäß linke Teil (Fig. 2a) zeigt die Remote- oder Downstream-Plasmaquelle 14 mit zugehörigem Plasma 10 im Beschichtungszustand und rechts die Remote- oder Downstream-Plasmaquelle 14 im geschlossenen Zustand (Fig. 2b) während des Reinigungsätzens.

Fig. 3 zeigt eine spezielle Ausführung mit lineare Plasmaquellen 15, 16 jeweils innerhalb eines Gehäuses 6, 7, wobei im Unterschied zu den vorher gehenden Ausführungen zur Abschirmung des Plasmas 10, 11 von den Substraten 4 auf dem Substratträger 5 Drehschieber 17, 18 vorgesehen sind.

Auf der zeichnungsgemäß linken Seite von Fig. 3 ist der Drehschieber 17 in der geschlossenen, also der Reinigungsposition dargestellt und auf der zeichnungsgemäß rechten Seite in geöffneter Position.

Die Erfindung ist auch für solche Plasmareaktoren geeignet, bei denen aus prozesstechnischen Gründen mehrere Plasmaquellen 2, 3; 14; 15, 16 nebeneinander angeordnet sind, um auf den Substraten beispielsweise einen Mehrschichtaufbau herzustellen. Werden hier sämtliche Gehäuse 6, 7 erfindungsgemäß ausgestattet, so können ohne Unterbrechung des Beschichtungsvorganges einzelne Plasmaquellen abgetrennt und in-situ gereinigt werden.

### Bezugszeichenliste

- 1: Prozesskammer
- 2: Plasmaquelle
- 3: Plasmaquelle
- 4: Substrat
- 5: Substratträger
- 6: Gehäuse
- 7: Gehäuse
- 8: Zuführeinrichtung
- 9: Zuführeinrichtung
- 10: Plasma
- 11: Plasma
- 12: Schieber
- 13: Schieber
- 14: Remote- oder Downstream-Plasmaquelle
- 15: lineare Plasmaquelle
- 16: lineare Plasmaquelle
- 17: Drehschieber
- 18: Drehschieber

## Patentansprüche

1. Plasmareaktor zur Oberflächenbeschichtung oder - modifikation von Gegenständen bzw. Substraten mit Plasmaverfahren in einer Prozesskammer mit Plasmaquellen, vorzugsweise bei reduziertem Druck als Vakuumprozess, mit einer Eingangsschleuse zur Prozesskammer, sowie einer Ausgangsschleuse, **dadurch gekennzei chnet**, **dass** in der Prozesskammer (1) mehrere, mindestens jedoch zwei Plasmazonen mit jeweils zugehörigen Plasmaquellen ( 2, 3; ; 15, 16) vorgesehen sind, wobei die Substrate (4) an den Plasmaquellen ( 2, 3; 10, 11; 15, 16) bzw. Remote- oder Downstream-Plasmaquellen (14) vorbei führbar sind und dabei den durch das Plasma mindestens einer der Plasmaquellen (2, 3; 15, 16) bzw. den Remote- oder Downstream-Plasmaquellen (14) chemisch aktivierten Prozessgasen ausgesetzt sind und dass mindestens eine der Plasmaquellen (2, 3; 14; 15, 16) selektiv von den zu bearbeitenden Substraten (4) und der Prozesskammer (1) isolierbar sind und dass der oder den isolierten Plasmaquellen (2, 3; 14; 15, 16) und dem sie umgebenden Bereich der Prozesskammer (1) ein Ätzgas zuführbar ist.

2. Plasmareaktor nach Anspruch 1, **dadurch geken nzeichnet**, **dass** für die Isolation einzelner Plasmaquellen ( 2, 3; 14; 15, 16) Abdichtungen vorgesehen sind.

3. Plasmareaktor nach Anspruch 2, **dadurch geken nzeichnet**, **dass** für die Isolation der Plasmaquellen (2, 3; 14; 15, 16) Schieber (12, 13) vorgesehen sind.

4. Plasmareaktor nach Anspruch 2, **dadurch geken nzeichnet**, **dass** für die Isolation von linearen Plasmaquellen (15, 16) jeweils ein vor diese schwenkbarer Drehschieber (17, 18) vorgesehen ist.

5. Plasmareaktor nach Anspruch 4, **dadurch geken nzeichnet**, **dass** der Drehschieber (17, 18) bei Nichtgebrauch hinter die lineare Plasmaquelle (15, 16) schwenkbar ist.

6. Plasmareaktor nach Anspruch 4 und 5, **dadurch ge kennzeichnet**, **dass** die Drehschieber (17, 18) jeder linearen Plasmaquelle (15, 16) aus Zylindersegmenten besteht.

7. Plasmareaktor nach einem der Ansprüche 1 bis 6, **dadu rch gekennzeichnet**, **dass** die Isolation einzelner Plasmaquellen (1, 2; 10, 11; 15, 16) durch eine geeignete Gasführung in der Prozesskammer erfolgt.

8. Plasmareaktor nach einem der Ansprüche 1 bis 7, **dadu rch gekennzeichnet**, **dass** zwischen der jeweils isolierten Plasmaquelle (2, 3;14; 15, 16) und den übrigen Plasmaquellen (2, 3;14; 15, 16) ein Druckunterschied besteht.
